(19) Europäisches Patentamt
European Patent Office
Office européen des brevets

(11) EP 2 863 232 B1

(12) **FASCICULE DE BREVET EUROPEEN**

(45) Date de publication et mention de la délivrance du brevet:
**05.12.2018 Bulletin 2018/49**

(21) Numéro de dépôt: **14187654.0**

(22) Date de dépôt: **03.10.2014**

(51) Int Cl.:
***G01R 19/25*** *(2006.01)* ***G01R 21/06*** *(2006.01)*
***G01R 21/133*** *(2006.01)* ***G01R 22/10*** *(2006.01)*
***G05F 1/66*** *(2006.01)*

(54) **Procédé de détermination d'une consommation individuelle de puissance**

Verfahren zur Bestimmung eines individuellen Leistungsverbrauchs

Method for determining individual power consumption

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.10.2013 FR 1302399**

(43) Date de publication de la demande:
**22.04.2015 Bulletin 2015/17**

(73) Titulaire: **Schneider Electric Industries SAS**
**92500 Rueil-Malmaison (FR)**

(72) Inventeur: **Bruel, Marc**
**38700 Corenc (FR)**

(74) Mandataire: **Talbot, Alexandre**
**Cabinet Hecké**
**28 Cours Jean Jaurès**
**38000 Grenoble (FR)**

(56) Documents cités:
**CN-U- 202 563 077**
**FR-A1- 2 984 516**
**JP-A- 2007 052 006**
**JP-A- 2008 185 435**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 863 232 B1

## Description

### Domaine technique de l'invention

L'invention est relative à un procédé de détermination d'une consommation individuelle de puissance dans une installation électrique comprenant un groupe de plusieurs branches de distribution individuelle d'électricité entre plusieurs charges, ainsi qu'une ligne principale amont raccordant le groupe de branches à une alimentation électrique.

L'invention concerne également un système de suivi d'une consommation individuelle de puissance dans une installation électrique.

### État de la technique

Les particuliers comme les autres agents économiques montrent un intérêt croissant pour la maîtrise de leurs propres consommations électriques. Un axe de cette maîtrise repose sur une connaissance détaillée de différentes consommations particulières à l'intérieur d'une consommation globale. Par exemple, les habitants d'une maison peuvent s'intéresser à leur consommation électrique due au chauffage, à celle consacrée à l'éclairage et/ou celle due à tel équipement, sans se satisfaire de la seule connaissance de la consommation globale à l'échelle du logement.

A l'heure actuelle, les habitants d'un logement peuvent avoir accès à leur consommation électrique globale, grâce à un compteur de consommation électrique équipant la ligne de raccordement au réseau public de distribution d'électricité. Lorsque l'on souhaite connaître une consommation individuelle par exemple d'un équipement au sein du logement, on équipe d'un compteur de consommation électrique la branche sur laquelle est connecté cet équipement.

La figure 1 annexée est un schéma représentant un exemple actuel d'installation électrique domestique, dans lequel plusieurs compteurs de consommation électrique 101 renseignent sur plusieurs consommations individuelles de puissance P1, P2, P3 constitutives d'une consommation de puissance globale P.

Sur cette figure 1, la référence 102 désigne un transformateur de raccordement à un réseau public de distribution d'électricité. Une arrivée amont 103 raccorde ce transformateur 102 à plusieurs départs ou branches 104 de distribution d'électricité. Dans l'exemple de la figure 1, seuls trois branches ont été représentées. Les branches 104 alimentent des charges 105 correspondant aux équipements du logement.

L'arrivée amont 103 est équipée d'un compteur de consommation électrique 106. Chaque branche de distribution d'électricité 104 est en outre équipée d'un compteur de consommation électrique 101, identique ou semblable au compteur 106. Chaque compteur 101 ou 106 détermine une consommation de puissance (individuelle ou globale), en mesurant le courant ($I$ ; $I_1$, $I_2$, $I_3$) et la tension ($U$ ; $U_1$, $U_2$, $U_3$) de la ligne qu'il équipe. Un réseau filaire est prévu pour acheminer les différents comptages à une centrale électronique de mesure 107, qui rassemble ces comptages.

Un compteur de consommation électrique est à la fois coûteux et encombrant. Lorsqu'on souhaite pouvoir suivre plusieurs consommations individuelles à l'intérieur d'une installation, le surcoût résultant de la multiplication des compteurs de consommation électrique devient conséquent et peut constituer un véritable frein à la mise en place d'un système de suivi de consommations individuelles. La possibilité d'une telle multiplication de compteurs peut en outre se heurter au manque d'espace disponible dans nombre de tableaux généraux électriques actuellement en service chez les particuliers.

Il existe donc un besoin de prévoir un système de suivi de consommations individuelles compact et économique.

La demande de brevet FR2984516 décrit une centrale de mesure des puissances individuelles, qui répond en partie seulement à ce besoin. Ce type de solution est commercialisé par la société demanderesse sous la désignation BCPM (pour « Branch Circuit Power Meter » en anglais).

La figure 2 représente schématiquement la centrale de mesure multi-branches BCPM décrite dans la demande précitée.

Comme sur la figure 1, un compteur de consommation électrique 106 équipe l'arrivée amont 103. Ce compteur mesure la tension globale d'alimentation U, ainsi que les valeurs d'intensité et de déphasage du courant global d'alimentation I. Par contre, chaque branche de distribution 104 dont on veut déterminer la consommation est désormais équipée d'un capteur de courant ou ampèremètre 201, plutôt qu'un autre compteur de consommation.

Enfin, une centrale de mesure 202 recueille et enregistre dans le temps les données en provenance du compteur 106 et des ampèremètres 201, puis calcule les différentes consommations de puissance, globale ou individuelles, à partir de ces données.

L'inconvénient de cette solution est son coût encore élevé (bien qu'un capteur de courant soit moins coûteux qu'un compteur de consommation électrique), et la nécessité d'installer un capteur de courant sur chaque départ. En effet, lorsqu'on utilise des capteurs de courant toroïdaux, cette installation requiert de démonter le tableau électrique du logement, pour glisser un capteur de courant torique autour de chaque départ. En outre, la place disponible dans le tableau n'est pas toujours suffisante pour installer des capteurs toroïdaux. L'utilisation de capteurs ouvrants n'est pas plus satisfaisante, car ils sont encore plus onéreux et encombrants que les capteurs toroïdaux.

### Résumé de l'invention

L'invention vise à réduire davantage le coût d'accès à la connaissance d'une consommation électrique individuelle constitutive d'une consommation électrique globale, au sein d'une installation électrique.

Selon l'invention, on tend vers cet objectif grâce à un procédé de détermination d'une consommation de puissance comme décrit dans la revendication 1, comprenant les étapes suivantes :

a) mesurer le courant circulant dans la ligne principale amont et la tension de la ligne principale amont ;

b) mesurer la tension d'au moins une branche de distribution individuelle, en aval d'un disjoncteur équipant la branche ;

c) déterminer le courant circulant dans la branche de distribution individuelle à partir de la différence entre la tension de la ligne principale amont et la tension de la branche de distribution individuelle ;

d) calculer la consommation individuelle de puissance de la branche de distribution individuelle à partir du courant et de la tension de la branche de distribution individuelle ;

e) calculer la puissance globale consommée par le groupe de branches à partir du courant et de la tension de la ligne principale amont ; et

f) corriger la consommation individuelle de puissance, de sorte qu'une variation instantanée de consommation électrique observée au niveau de la branche de distribution individuelle soit égale à une variation instantanée de consommation électrique observée simultanément au niveau de ligne principale amont.

L'invention vise également un système de suivi d'une consommation individuelle simplifié, comme décrit dans la revendication 9, afin d'en réduire le coût et l'encombrement, et faciliter son installation dans un tableau électrique.

Selon l'invention, on tend vers cet objectif en prévoyant :

- un appareil de mesure du courant et de la tension au niveau de la ligne principale amont, et de mesure de la tension d'au moins une branche de distribution individuelle en aval du disjoncteur,
- un compteur de la puissance globale consommée par le groupe de branche, à partir du courant et de la tension de la ligne principale amont ;
- un dispositif calculateur configuré pour calculer la consommation individuelle de puissance de la branche de distribution individuelle à partir d'un courant circulant dans la branche de distribution individuelle et de la tension de la branche de distribution individuelle ; et
- des moyens de correction de la consommation individuelle de puissance, par corrélation des variations instantanées de consommation électrique observées simultanément au niveau de la branche de distribution individuelle et de la ligne principale amont.

Le dispositif calculateur est configuré pour calculer le courant de la branche de distribution individuelle, à partir de la différence entre la tension de la ligne principale amont et la tension de la branche de distribution individuelle.

En outre, le procédé et le système comportent des étapes ou moyens supplémentaires de correction.

**Description sommaire des dessins**

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1, précédemment décrite, est un schéma électrique simplifié d'une installation électrique équipé d'un système de suivi des consommations de puissance selon l'art antérieur ;
- la figure 2, précédemment décrite, représente schématiquement un autre système de suivi des consommations de puissance selon l'art antérieur, dans l'installation électrique de la figure 1 ;
- la figure 3 représente schématiquement un système de suivi d'une consommation de puissance individuelle selon l'invention ;
- la figure 4 représente un mode de réalisation préférentiel du système de suivi selon l'invention ;
- la figure 5 représente les étapes d'un procédé mis en oeuvre par le système de suivi selon l'invention, pour déterminer la consommation de puissance d'une branche de distribution individuelle d'électricité ;
- la figure 6 représente un algorithme de correction implémenté dans le système de suivi de la figure 4, pour affiner le calcul de la consommation individuelle de puissance ;
- la figure 7 représente un autre algorithme de correction des consommations individuelles de puissance ; et
- la figure 8 représente une variante de l'algorithme de correction de la figure 7 ; et

- la figure 9 représente un procédé pour déterminer la résistance de contact d'un disjoncteur équipant chaque branche de distribution individuelle d'électricité.

**Description d'un mode de réalisation préféré de l'invention**

Sur la figure 3 est représentée une installation électrique 1 adaptée pour le suivi des consommations individuelles d'électricité. Dans un souci de clarté, la figure 3 est simplifiée et certains constituants classiques de l'installation y sont omis. En particulier, seul un conducteur de phase est représenté, alors que le conducteur de neutre ne l'est pas.

L'installation électrique 1 peut appartenir à un consommateur final d'électricité et se trouver dans un bâtiment, tel qu'un logement de particuliers ou un immeuble de bureaux, où il existe plusieurs charges distinctes à alimenter et où il y a lieu d'effectuer une distribution d'énergie électrique.

L'installation électrique 1 comprend classiquement une ligne principale amont ou arrivée 2 et un groupe de branches 3 de distribution individuelle d'électricité connectées à l'arrivée 2. Les branches 3 alimentent en électricité des charges 4 correspondant aux équipements du bâtiment.

L'installation 1 est raccordée à une alimentation électrique 5 en courant alternatif ou courant continu par l'arrivée 2. L'alimentation 5 peut notamment être un réseau public de distribution d'électricité.

L'arrivée 2 débouche dans un tableau général basse tension 6, où plusieurs départs sont connectés à l'arrivée 2. Chacun d'eux fait partie de l'une des branches de distribution 3 qui se dispersent dans le bâtiment. Dans l'exemple de la figure 3, ces branches 3 sont au nombre de trois. Il va de soi que leur nombre peut être différent de trois.

Chaque départ 3 est équipé d'un disjoncteur 7 permettant d'interrompre l'alimentation de la charge 4, notamment en cas de surtension ou de rupture du conducteur de neutre. En position fermée, ce disjoncteur présente une impédance faible, principalement résistive, de l'ordre de 10 mΩ.

Afin de minimiser l'appareillage nécessaire à la détermination d'une consommation électrique dans l'une des branches de distribution individuelle 3, on propose d'exploiter la chute de tension qui apparait aux bornes du disjoncteur 7 équipant cette branche.

En effet, il a été observé que le disjoncteur 7 se comporte comme une résistance « shunt » en position fermée. La chute de tension dans le disjoncteur 7 varie quasiment de façon linéaire avec le courant qui le traverse. Par conséquent, la mesure des tensions en amont et en aval du disjoncteur 7 permet d'estimer le courant circulant dans la branche 3, puis la puissance électrique consommée par cette branche.

La figure 3 représente schématiquement un système de suivi 8 des consommations individuelles de puissance, qui applique ce principe dans l'installation électrique 1. Les branches sont ici numérotées de 1 à 3. $U_i$ et $I_i$ désignent respectivement la tension et le courant d'une branche de rang i (i valant de 1 à 3).

En régime alternatif, il y a lieu de distinguer la puissance active $P_i$ et la puissance réactive $Q_i$ consommée par la branche de distribution individuelle de rang i. Le système de suivi 8 décrit ci-après est capable de mesurer l'une ou l'autre de ces grandeurs qui caractérisent l'énergie électrique fournie par la branche, voire les deux simultanément. En régime continu, cette distinction n'existe pas et le système déterminera la puissance électrique $P_i$ d'une ou plusieurs branches.

Le système de suivi 8 comporte un appareillage 8a pour mesurer le courant I circulant dans l'arrivée 2, la tension U de cette arrivée 2 et la tension $U_i$ d'au moins une branche de distribution 3, en aval du disjoncteur 7. Cet appareillage de mesure se compose donc d'au moins un capteur de courant, un voltmètre et deux fils reliant le voltmètre à la ligne principale 2 et à l'une des branches 3 en aval du disjoncteur 7.

Comme cela est représenté sur la figure 3, l'appareillage de mesure 8a comporte avantageusement autant de fils de connexion qu'il y a de branches 3, afin de mesurer la tension de toutes les branches. Dans cet exemple, on dispose alors de trois valeurs de tension $U_1$, $U_2$ et $U_3$. Comparées à la tension globale d'alimentation U, ces valeurs permettront de calculer les courants $I_1$, $I_2$ et $I_3$ des trois branches de distribution, puis leurs consommations de puissance respectives $P_1/Q_1$, $P_2/Q_2$ et $P_3/Q_3$.

Le système 8 comporte en outre un dispositif calculateur 8b, configuré pour calculer la puissance active $P_i$ et/ou réactive $Q_i$ consommée par une branche d'indice i à partir des valeurs de tension U, $U_i$ et de courant I. Outre la puissance active $P_i$ et réactive $Q_i$, le dispositif calculateur 8b est capable de calculer le facteur de puissance $PF_i$ (en régime alternatif seulement) de la branche i et une valeur moyenne $I_{Mi}$ du courant circulant dans cette branche (régime alternatif ou continu).

La figure 4 représente en détail un mode de réalisation préférentiel du système de suivi 8 des consommations individuelles de puissance. Dans ce mode de réalisation préférentiel, une partie de l'instrumentation de mesure et le calculateur sont regroupés dans une même électronique pour former un dispositif 9 unique, appelé centrale de mesure des consommations de puissance BCPM (« Branch Circuit Power Meter »).

L'arrivée 2 est équipée d'un capteur de courant, de sorte à mesurer le courant I qui y circule. Grâce au courant I et la tension U de l'arrivée 2, la centrale 9 détermine la puissance globale P consommée par le groupe de branches. Un compteur de consommation électrique 10, comme celui utilisé dans les solutions de l'art antérieur, peut être prévu à cet effet.

Dans ce mode de réalisation préférentiel, le compteur de consommation électrique 10 est intégré à la centrale de mesure 9. Ainsi, deux des entrées de la centrale 9 sont prévues pour la tension U et le courant I de l'arrivée 2 et connectées au compteur 10.

Dans l'exemple de la figure 4, la centrale 9 compte trois autres entrées, correspondent aux prises de tension $U_1$, $U_2$ et $U_3$ dans les trois branches de distribution 3. A chacune de ces entrées est connecté un comparateur 11. Il y a donc autant de comparateurs 11 qu'il y a de branches de distribution 3.

Chaque comparateur 11 est configuré pour calculer la chute de tension $\Delta U_i$ aux bornes du disjoncteur 7 de la branche 3 à laquelle il est associé. Cette chute de tension est égale à la différence entre la tension « amont » U de l'arrivée 2 et la tension « aval » $U_i$ de la branche 3. Ainsi, chaque comparateur 11 reçoit en entrée la tension U et l'une des tensions $U_1$, $U_2$ et $U_3$. A titre d'exemple, le comparateur 11 associé à la branche de rang 1 calcule la chute de tension $\Delta U_1$ à partir des tensions U et $U_1$ ($\Delta U_1 = U - U_1$). La chute de tension $\Delta U_i$ est globalement proportionnelle au courant $I_i$ circulant dans une branche. Chaque comparateur 11 délivre en sortie une image $I_i$' du courant circulant dans la branche associée, en divisant la chute de tension $\Delta U_i$ par une valeur typique de la résistance shunt du disjoncteur 7. Les courants image des trois branches sont notés $I_1$', $I_2$' et $I_3$' sur la figure 4.

En sortie de chaque comparateur 11 est connectée une unité de calcul 12 de puissance électrique. Chaque unité de calcul 12 reçoit la tension $U_i$ et le courant image $I_i$' de la branche dont on veut déterminer la consommation individuelle de puissance $P_i$'. Trois unités de calcul 12 sont ainsi prévues pour calculer les consommations de puissance $P_1$', $P_2$' et $P_3$' des trois branches de distribution 3.

De préférence, les unités de calcul 12 sont, dans leur réalisation, identique ou semblable au compteur de consommation électrique 10.

Les valeurs de puissance électrique $P_1$', $P_2$' et $P_3$' en sorties des unités de calcul 12 sont approchées, car elles se basent sur une estimation du courant ($I_i$') dans les branches de distribution 3, et plus particulièrement sur la résistance équivalente des disjoncteurs 7. Or, cette résistance évolue dans le temps, notamment à cause des ouvertures/fermetures successives du disjoncteur, de l'usure des contacts du disjoncteur au fil du temps et de réchauffement par effet Joule de ces contacts.

Pour tenir compte de cette évolution et rendre plus précis le calcul de la consommation individuelle de puissance, le système de suivi 8 réalise une corrélation entre les valeurs approchées de puissance individuelle $P_1$', $P_2$', $P_3$' et la mesure précise de la puissance globale P effectuée par le compteur 10.

Les consommations de puissance P, $P_i$' calculées par le compteur 10 et les unités de calcul 12 alimentent un microprocesseur $\mu$P. Le microprocesseur $\mu$P est, de préférence, équipé d'une mémoire, dans lequel il enregistre, entre autres, plusieurs valeurs de ces puissances et courants étalées dans le temps.

Des algorithmes de calibration sont également stockés dans la mémoire. Comme cela sera décrit plus loin, le microprocesseur $\mu$P met en oeuvre ces algorithmes pour corriger les valeurs approchées des consommations individuelles de puissance $P_1$', en des valeurs précises $P_i$.

En plus de la centrale 9 et des capteurs de courant/tension équipant l'arrivée 2, le système de suivi 8 ne requiert qu'une prise de tension au niveau de la branche de distribution individuelle 3, pour déterminer sa consommation de puissance. Or, une prise de tension est bien moins contraignante que l'utilisation d'un capteur de courant. Elle se résume à un seul fil, alors qu'une prise de courant nécessite au moins deux fils, un capteur et des opérations de câblage.

L'appareillage de mesure du système de suivi 8 est donc simplifié par rapport aux systèmes de suivi classiques, qui emploient un compteur de consommation ou un capteur de courant dans chaque branche de distribution. Sa mise en place dans une installation électrique en est grandement facilitée.

En outre, le fil utilisé pour une prise de tension est de section plus faible que les fils d'un capteur de courant. Par conséquent, ce système de suivi est compact et adapté aux tableaux électriques où la place disponible est faible.

Ainsi, le système de suivi de la figure 4 est bien moins onéreux et encombrant que les systèmes de suivi classiques. A titre d'exemple, dans une installation électrique triphasée à huit branches de distribution, le système de suivi 8 ne requiert qu'un seul appareil (centrale 9), trois capteurs de courant (1 par phase de l'arrivée amont) et 27 prises de tension (3 en amont et 24 en aval). Le système de la demande FR2984516 requiert quant à lui trois capteurs de tension (en amont) et 27 capteurs de courant (3 en amont et 24 en aval), en plus de la centrale de mesure BCPM. Enfin, en multipliant les compteurs de consommation électrique, il faudrait neuf compteurs (1 par ligne/branche), 27 capteurs de courant et 27 capteurs de tension (3 par ligne/branche).

Le système de suivi décrit ci-dessus est adapté à tout type d'installation électrique, notamment à courant continu ou courant alternatif (sinusoïdal par exemple), monophasée ou triphasée. En mode alternatif, il tient compte du déphasage entre le courant et la tension, afin notamment de déterminer les consommations de puissance active et réactive.

Outre la consommation de puissance, le système peut donner une indication sur l'état du disjoncteur d'une branche : ouvert ou fermé. En effet, si la différence de tensions amont-aval $\Delta U_i$ est faible, de l'ordre de 100 mV, le disjoncteur est à l'état fermé. Cette différence de tension correspond à la résistance « shunt » du disjoncteur. Lorsque que le disjoncteur s'ouvre, par exemple à cause d'un déclenchement, la tension $\Delta U_i$ mesurée aux

bornes du disjoncteur devient égale à la tension nominale d'alimentation, par exemple 230V. Dans ce deuxième cas, l'image de courant $I_i$' fourni par le comparateur 11 sera évidemment fausse. Toutefois, comme la tension aval $U_i$ est nulle, la puissance individuelle calculée $P_i$' sera également nulle, ce qui constitue un résultat cohérent.

La figure 5 résume les étapes F1 à F6 du procédé mis en oeuvre par le système de suivi de la figure 4, pour déterminer une ou plusieurs consommations individuelles de puissance.

Lors d'une première étape F1, la tension U et le courant I de la ligne principale 2 en amont de l'installation est mesurée.

Puis, lors d'une étape F2, on mesure en aval du disjoncteur 7 la tension $U_i$ de la branche de distribution 3 dont on veut déterminer la consommation.

A l'étape F3, le système de suivi détermine une valeur approximative du courant $I_i$ circulant dans le disjoncteur 7 et la branche de distribution 3, à partir de la différence des valeurs U et $U_i$.

En F4, une valeur approximative $P_i$' de la puissance électrique consommée par la branche 3 est déterminée, connaissant la tension $U_i$ et le courant $I_i$.

A l'étape F5, on détermine la puissance globale P consommée par le groupe de branches 3 à partir du courant global I et de la tension globale d'alimentation U (mesurés à l'étape F1).

Enfin, l'étape F6 consiste à corriger individuellement chaque consommation de puissance Pi' pour compenser le manque de précision due à l'image du courant. Pour ce faire, on définit, pour chaque branche de distribution, un coefficient de correction $\alpha_i$ que multiplie la consommation de puissance $P_i$' de la branche.

$$P_i = P_i' \times \alpha_i$$

Ce coefficient de correction $\alpha_i$ est spécifique à chaque branche de distribution 3. Au premier démarrage du système de suivi, sa valeur est égale à 1. Puis, au fil du temps, il est mis à jour par le microprocesseur $\mu$P. Les valeurs initiale et courante du coefficient de correction $\alpha_i$ sont stockées, pour chaque branche, dans la mémoire du microprocesseur $\mu$P.

La valeur courante du coefficient $\alpha_i$ est déterminée par un algorithme, qui compare des variations instantanées de consommation électrique observées simultanément au niveau de la ligne principale amont 2 et au niveau de la branche de distribution 3. Le coefficient correcteur $\alpha_i$ est calculé, de sorte qu'une variation de puissance dans la branche de distribution 3 soit égale à la variation de puissance dans la ligne principale amont 2.

La figure 6 représente, sous la forme d'un organigramme, l'algorithme mis en oeuvre par le microprocesseur, pour déterminer la valeur du coefficient correcteur $\alpha_i$ à appliquer à l'étape F6.

L'algorithme de la figure 6 comporte trois étapes F61 à F63 qui sont mises en oeuvre, de préférence, après chaque fermeture du disjoncteur 7, c'est-à-dire dès lors qu'un courant électrique est rétabli dans la branche de distribution 3. Ainsi, on peut prendre en compte l'évolution de la résistance de contact du disjoncteur dans le calcul de la consommation de puissance.

Lors d'une étape F61, le système de suivi surveille l'ensemble des puissances individuelles $P_i$ corrigées à l'étape F6, jusqu'à détecter une variation $\Delta P_i$ de l'une des branches de distribution. Une variation $\Delta P_i$ de la puissance individuelle est, de préférence, détectée dès lors qu'elle dépasse un seuil de détection, par exemple 5 % de la puissance nominale consommée par cette branche. Simultanément, le système détecte une variation de la puissance globale P, notée $\Delta P$.

Cette surveillance est, de préférence, effectuée en continu par le microprocesseur $\mu$P, puisque celui-ci enregistre dans le temps les valeurs de puissance globale P et individuelle(s) corrigée(s) $P_i$.

A l'étape F62, un coefficient de calibration $R_i$ est calculé par le microprocesseur $\mu$P. Ce coefficient $R_i$ est égal au rapport de la variation de puissance individuelle $\Delta P_i$ sur la variation de puissance globale $\Delta P$ :

$$R_i = \frac{\Delta P_i}{\Delta P}$$

En F63, le coefficient de correction individuelle est mis à jour au moyen du coefficient de calibration $R_i$ calculé à l'étape F62. Une nouvelle valeur $\alpha_i$' du coefficient est calculée, en divisant la valeur existante $\alpha_i$ par le coefficient $R_i$ calculé à l'étape F62 :

$$\alpha_i' = \frac{\alpha_i}{R_i} \qquad (1)$$

Enfin, la nouvelle valeur $\alpha_i$' du coefficient correcteur vient remplacer l'ancienne valeur $\alpha_i$ en mémoire.

Bien sûr, après la mise à jour du coefficient de correction $\alpha_i$ à l'étape F63, la valeur estimée $P_i$' de la puissance individuelle est à nouveau corrigée :

$$P_i = P_i' \times \alpha_i$$

L'algorithme de la figure 6 permet, d'une certaine manière, de calibrer la résistance de shunt d'un disjoncteur, en supposant qu'une variation de puissance globale est causée par une variation identique de la puissance d'une branche de distribution. Cet algorithme n'est donc applicable que si une seule des branches voit sa consommation bouger à un instant donné. Si les puissances de deux branches varient simultanément, il n'est plus possible de les différencier et de les attribuer à la variation de puissance globale. Dans ce cas, les étapes F62 à F63 sont mises en attente, jusqu'à ce qu'une branche se distingue du reste du groupe.

Parce qu'elle est effectuée à chaque variation de puissance dans la branche de distribution individuelle, cette calibration peut être qualifiée de dynamique.

L'algorithme de la figure 6 peut être mis en oeuvre une fois pour chaque branche de distribution à l'initialisation du système de suivi, après que celui-ci ait été relié à l'installation électrique. Les disjoncteurs de toutes les branches sont alors ouverts, puis refermés, l'un après l'autre pour forcer des variations de puissance. Alors, l'algorithme s'initie pour chaque branche. On peut aussi attendre que des variations spontanées apparaissent.

Dans un mode de réalisation préférentiel, chaque mise à jour du coefficient $\alpha_i$ à l'étape F63 est suivie d'un autre algorithme de calibration. Ce deuxième algorithme est représenté à la figure 7 et comprend les étapes F71 et F72. Il utilise, pour chaque branche de distribution, le même coefficient de correction $\alpha_i$ que celui utilisé pour l'algorithme de la figure 6.

Contrairement à celle de la figure 6, la calibration de la figure 7 s'effectue à l'échelle du groupe de branches. Les coefficients de correction $\alpha_i$ sont modifiés d'une même façon, pour que la consommation de puissance globale P corresponde bien à la somme des consommations individuelles de puissance $P_i$.

Cette nouvelle façon de déterminer les coefficients de correction $\alpha_i$ suppose donc de connaître toutes les consommations individuelles de puissance du groupe. Ainsi, les étapes F1 à F4 du procédé de détermination de la figure 6 auront été appliquées à l'ensemble des branches du groupe.

A l'étape F71, un coefficient de correction globale $\alpha_g$ est calculé d'après l'équation suivante :

$$\alpha_g = \frac{\sum_{i=1}^{n} P_i}{P}$$

Le coefficient $\alpha_g$ est égal à la somme des puissances individuelles $P_i$ de toutes les branches de distribution (*n* branches), qui ont été corrigées à l'étape F6, divisée par la puissance globale P.

Les coefficients de correction individuelle $\alpha_i$ sont ensuite mis à jour (étape F72), par le coefficient de correction globale $\alpha_g$. La nouvelle valeur $\alpha_i$' des coefficients se calcule de la manière suivante :

$$\alpha_i' = \frac{\alpha_i}{\alpha_g} \qquad (2)$$

Comme précédemment, à chaque modification des coefficients $\alpha_i$, les valeurs correctes $P_i$ des puissances individuelles sont à nouveau calculées, en prenant en compte les valeurs des coefficients modifiées à l'étape F72.

$$P_i = P_i' \times \alpha_i$$

A l'issue de cette nouvelle correction, le système de suivi est globalement équilibré, c'est-à-dire que la somme des consommations de puissance individuelle $P_i$ équivaut à la consommation de puissance globale P.

Ainsi, dans ce mode de réalisation préférentiel, les coefficients de correction $\alpha_i$ sont modifiés concurremment par les deux algorithmes à travers les relations (1) et (2) ci-dessus.

De préférence, l'algorithme de la figure 7 est également enclenché une fois après l'installation du système de suivi 8.

Dans une variante de mise en oeuvre représentée à la figure 8, le déclenchement du deuxième algorithme peut être en plus conditionné par une étape F70 vérifiant si la puissance globale P mesurée par le compteur de consommation 10 dépasse un seuil, par exemple 20 % de la puissance nominale $P_{rp}$ du groupe de branche. Cela permet d'éviter de lancer l'algorithme trop souvent, pour des variations trop faibles.

Si la puissance globale P est supérieure au seuil (sortie OUI), la calibration globale de la figure 7 a lieu, c'est-à-dire qu'on procède aux étapes F71 et F72 comme indiqué ci-dessus. Si la puissance globale P est inférieure au seuil (sortie NON), rien ne se passe : les coefficients $\alpha_i$ ne seront pas mis à jour pour l'instant. Alors, on reboucle en entrée de l'étape F70, pour vérifier ultérieurement si la condition est désormais remplie.

On constate que d'autres paramètres électriques peuvent être calculées, dès lors qu'on dispose des valeurs précises $P_i$ des consommations individuelles de puissance. En particulier, il est possible de calculer le facteur de puissance $PF_i$ lié à chaque branche de distribution et, de façon précise cette fois, le courant de la branche, ou plus exactement une valeur moyenne $I_{Mi}$ de ce courant.

Le facteur de puissance $PF_i$ de la branche i s'écrit comme suit :

$$PF_i = \frac{P_i}{\sqrt{{P_i}^2 + {Q_i}^2}}$$

Le courant moyen $I_{Mi}$ circulant dans la branche i s'écrit :

$$I_{Mi} = \frac{P_i}{PF_i \times U}$$

Comme indiqué précédemment, la correction dynamique de la figure 6 vise à compenser les variations de la résistance de contact du disjoncteur dans le calcul des consommations de puissance, car les contacts du disjoncteur peuvent s'user ou se déplacer légèrement après chaque cycle d'ouverture/fermeture.

Il est en fait possible d'aller plus loin encore et de calculer directement cette résistance de contact. Cela permet de surveiller l'usure des contacts dans le temps et déclencher, si besoin, des opérations de maintenance du disjoncteur. En outre, la valeur de la résistance de contact obtenue pourra servir au calcul des images de courant $I_i$' à partir de la différence de tensions amont-aval, à l'étape F3 du procédé de la figure 5.

La figure 8 représente un troisième algorithme, qui est avantageusement implémenté dans le microprocesseur $\mu$P de la centrale, avec les algorithmes de calibration des figures 6 et 7.

Cet l'algorithme constitue un moyen simple et rapide de déterminer la résistance de contact $RC_i$ d'un disjoncteur. Comme pour la détermination des consommations de puissance $P_i$', le calcul de la résistance de contact repose sur la différence de tensions amont-aval, mesurée aux bornes du disjoncteur. Cette fonction supplémentaire peut donc être obtenue avec le même appareillage de mesure et le même dispositif calculateur, que ceux décrit précédemment.

Ce troisième algorithme comprend, de préférence, des étapes F81 à F83 relatives à la détermination d'une valeur initiale de la résistance de contact du disjoncteur, si une telle valeur n'a pas été enregistrée au préalable dans la mémoire du microprocesseur $\mu$P. Les étapes F81 à F83 sont avantageusement mises en oeuvre lorsque le disjoncteur est fermé pour la première fois après l'installation du système. Cette valeur initiale pourra servir de référence, afin de contrôler la dérive de la résistance de contact au fil du temps.

Ainsi, en F81, le microprocesseur vérifie s'il dispose d'une valeur initiale de la résistance de contact, notée $RC_{i(ini)}$. Si la valeur $RC_{i(ini)}$ n'existe pas (sortie NON), le microprocesseur passe à une étape F82 de calcul de cette valeur, puis l'enregistre dans sa mémoire lors d'une étape F83.

Le calcul est, de préférence, réalisé en utilisant l'équation suivante :

$$RC_{i(\text{ini})} = \frac{U - U_i}{I_{Mi}},$$

dans laquelle U est la tension de la ligne principale amont, $U_i$ est la tension de la branche de distribution individuelle et $I_{Mi}$ le courant moyen circulant dans cette branche (qui est aussi calculé par le microprocesseur $\mu$P).

Si la valeur initiale $RC_{i(ini)}$ existe (sortie OUI en F81), l'algorithme saute les étapes F82-F83 et passe directement à une phase d'attente F84. L'étape d'attente F84 définit une périodicité à laquelle de nouvelles valeurs de la résistance de contact $RC_i$ sont calculées. A titre d'exemple, elle peut durer entre 10 minutes et 1 heure.

Passée cette phase d'attente, le microprocesseur $\mu$P procède en F85 au calcul d'une nouvelle valeur de la résistance de contact $RC_i$, à l'aide des nouvelles valeurs de tension U, $U_i$ et de courant moyen $I_{Mi}$ fournies par le système :

$$RC_i = \frac{U - U_i}{I_{Mi}}$$

A l'étape F86, cette valeur $RC_i$ est comparée à un seuil représentatif d'un défaut du disjoncteur. Ce seuil est, de préférence, un multiple de la valeur initiale $RC_{i(ini)}$, par exemple trois fois la valeur initiale $RC_{i(ini)}$.

Si la valeur $RC_i$ est supérieure au seuil (sortie OUI en F86), une alarme est déclenchée en F87 pour signaler que le disjoncteur est défectueux. Un changement du disjoncteur de la branche pourra alors avoir lieu. Si par contre la valeur $RC_i$ est inférieure au seuil (sortie NON), le disjoncteur est supposé fiable et aucune opération de maintenance n'aura lieu. L'algorithme de la figure 8 reboucle à l'étape F84, pour effectuer ultérieurement un nouveau contrôle de la résistance de contact (F85-F86).

Dans une variante de mise en oeuvre (non représentée), après la phase d'attente F84 ou en substitution de celle-ci, le calcul F85 d'une nouvelle valeur peut être déclenché lorsque le courant moyen $I_{Mi}$ de la branche dépasse un seuil. Ainsi, les calculs de résistance de contact sont plus significatifs. Ce seuil est, de préférence, un pourcentage du courant nominal de la branche, par exemple 20 % de ce courant nominal. Le courant nominal est défini comme étant le courant auquel le disjoncteur est calibré, c'est-à-dire le seuil de courant qui fait disjoncter la branche.

## Revendications

**1.** Procédé de détermination d'une consommation individuelle de puissance dans une installation électrique (1) comportant un groupe de branches de distribution individuelle d'électricité (3) et une ligne principale amont (2) raccordant le groupe de branches à une alimentation électrique (5), chaque branche de distribution individuelle d'électricité comportant un disjoncteur (7),
procédé comprenant les étapes suivantes :

a) mesurer (F1) le courant (I) circulant dans la ligne principale amont et la tension (U) de la ligne principale amont ;
b) mesurer (F2) la tension ($U_i$) d'au moins une branche de distribution individuelle (3), en aval du disjoncteur (7) ;

c) déterminer (F3) le courant ($I_i$) circulant dans la branche de distribution individuelle à partir de la différence ($\Delta U_i$) entre la tension de la ligne principale amont et la tension de la branche de distribution individuelle ;

d) calculer (F4) la consommation individuelle de puissance ($P_i$') de la branche de distribution individuelle à partir du courant ($I_i$) et de la tension ($U_i$) de la branche de distribution individuelle ;

e) calculer (F5) la puissance globale (P) consommée par le groupe de branches à partir du courant (I) et de la tension (U) de la ligne principale amont ; et

f) corriger (F6) la consommation individuelle de puissance ($P_i$'), de sorte qu'une variation instantanée de consommation électrique observée au niveau de la branche de distribution individuelle soit égale à une variation instantanée de consommation électrique observée simultanément au niveau de ligne principale amont,

procédé dans lequel l'étape f) comprend les sous-étapes suivantes :

- affecter un coefficient de correction individuelle ($\alpha_i$) à la consommation individuelle de puissance ($P_i$') ;
- détecter (F61) simultanément une variation ($\Delta P_i$) de la consommation individuelle de puissance corrigée et une variation ($\Delta P$) de la puissance globale ;
- calculer (F62) un coefficient de calibration ($R_i$) égal au rapport entre les variations ($\Delta P_i$, $\Delta P$) de consommation individuelle de puissance et de puissance globale ;
- mettre à jour (F63) le coefficient de correction individuelle ($\alpha_i$) au moyen du coefficient de calibration ; et
- affecter le coefficient de correction individuelle ($\alpha_i$) à la consommation individuelle de puissance ($P_i$').

**2.** Procédé selon la revendication 1, dans lequel l'étape f) est effectuée à chaque fermeture du disjoncteur (7).

**3.** Procédé selon l'une quelconque des revendications 1 à 2, dans lequel les étapes b) à d) sont mises en oeuvre pour toutes les branches de distribution individuelle d'électricité (3).

**4.** Procédé selon la revendication 3, comprenant en outre l'étape suivante :
g) corriger (F7) la consommation individuelle de puissance ($P_i$') de chaque branche de consommation individuelle (3), de sorte que la somme des consommations individuelles de puissance corrigées ($P_i$) soit égale à la puissance globale (P).

**5.** Procédé selon la revendication 4, dans lequel l'étape g) comprend les sous-étapes suivantes :

- affecter un coefficient de correction individuelle ($\alpha_i$) à la consommation individuelle de puissance ($P_i$') de chaque branche de distribution individuelle (3) ;
- calculer (F71) un coefficient de correction globale égal au rapport entre la somme des consommations individuelles de puissance corrigées et la puissance globale (P) ;
- mettre à jour (F72) le coefficient de correction individuelle ($\alpha_i$) de chaque branche au moyen du coefficient de correction globale ($\alpha_g$) ; et
- affecter le coefficient de correction individuelle ($\alpha_i$) à la consommation individuelle de puissance ($P_i$') de chaque branche.

**6.** Procédé selon l'une quelconque des revendications 1 à 5, dans lequel le calcul de la consommation individuelle de puissance comprend le calcul de la puissance active individuelle ($P_i$) et de la puissance réactive individuelle ($Q_i$).

**7.** Procédé selon la revendication 6, comprenant des étapes de calcul d'un facteur de puissance ($PF_i$) de la branche de distribution individuelle et d'une valeur moyenne ($I_{iM}$) du courant circulant dans la branche de distribution individuelle (3).

**8.** Procédé selon la revendication 7, comprenant les étapes suivantes :

- calculer (F85) la résistance de contact ($RC_i$) du disjoncteur (7) de la branche individuelle, à partir de la différence entre la tension (U) de la ligne principale amont (2) et la tension ($U_I$) de la branche de distribution individuelle (3), et de la valeur moyenne ($I_{iM}$) du courant circulant dans la branche de distribution individuelle ;
- comparer (F86) la résistance de contact à une valeur seuil ; et
- déclencher (F87) une alarme lorsque la résistance de contact est supérieure à la valeur seuil.

**9.** Système de suivi d'une consommation individuelle de puissance dans une installation électrique (1) comportant un groupe de branches de distribution individuelle d'électricité (3) et une ligne principale amont (2) raccordant le groupe de branches à une alimentation électrique (5), chaque branche de distribution individuelle d'électricité comportant un disjoncteur (7),
le système de suivi comportant

• un appareil de mesure (8a) du courant (I) et de la tension (U) au niveau de la ligne principale amont, et de mesure de la tension ($U_i$) d'au moins une branche de distribution individuelle en aval du disjoncteur,

• un compteur (10) de la puissance globale (P) consommée par le groupe de branche, à partir du courant (I) et de la tension (U) de la ligne principale amont ;

• un dispositif calculateur (9) configuré pour calculer la consommation individuelle de puissance ($P_i$', $Q_i$') de la branche de distribution individuelle (3) à partir d'un courant ($I_i$) circulant dans la branche de distribution individuelle et de la tension ($U_i$) de la branche de distribution individuelle ; et

• des moyens de correction ($\mu$P) de la consommation individuelle de puissance ($P_i$'), par corrélation des variations instantanées de consommation électrique observées simultanément au niveau de la branche de distribution individuelle (3) et de la ligne principale amont (2) ;

système de suivi **caractérisé en ce que** le dispositif calculateur (9) est configuré pour calculer le courant ($I_i$) de la branche de distribution individuelle, à partir de la différence entre la tension (U) de la ligne principale amont et la tension ($U_I$) de la branche de distribution individuelle, et **en ce que** les moyens de correction ($\mu$P) sont configurés pour :

- affecter un coefficient de correction individuelle ($\alpha_i$) à la consommation individuelle de puissance ($P_i$') ;
- détecter (F61) simultanément une variation ($\Delta P_i$) de la consommation individuelle de puissance corrigée et une variation ($\Delta$P) de la puissance globale ;
- calculer (F62) un coefficient de calibration ($R_i$) égal au rapport entre les variations ($\Delta P_I$, $\Delta$P) de consommation individuelle de puissance et de puissance globale ;
- mettre à jour (F63) le coefficient de correction individuelle ($\alpha_i$) au moyen du coefficient de calibration ; et
- affecter le coefficient de correction individuelle ($\alpha_i$) à la consommation individuelle de puissance ($P_i$').

## Patentansprüche

**1.** Verfahren zur Bestimmung einer individuellen Leistungsaufnahme in einer elektrischen Anlage (1), das eine Gruppe von Strängen (3) zur individuellen Stromabgabe und eine vorgeschaltete Hauptleitung (2) umfasst, die die Gruppe von Strängen an eine Stromversorgung (5) anschließt, wobei jeder Strang zur individuellen Stromabgabe einen Schutzschalter (7) umfasst,
Verfahren, das folgende Schritte umfasst:

a) Messen (F1) des Stroms (I), der in der vorgeschalteten Hauptleitung fließt, und der Spannung (U) der vorgeschalteten Hauptleitung;
b) Messen (F2) der Spannung ($U_i$) mindestens eines Strangs (3) zur individuellen Abgabe hinter dem Schalter (7);
c) Bestimmung (F3) des Stroms ($I_i$) der in dem Strang zur individuellen Abgabe fließt, aus der Differenz ($AU_i$) zwischen der Spannung der vorgeschalteten Hauptleitung und der Spannung des Strangs zur individuellen Abgabe;
d) Berechnung (F4) der individuellen Leistungsaufnahme ($P_i$') des Strangs zur individuellen Abgabe aus dem Strom ($I_i$) und der Spannung (U) des Strangs zur individuellen Abgabe;
e) Berechnung (F5) der von der Gruppe der Stränge verbrauchten Gesamtleistung (P) aus dem Strom (I) und der Spannung (U) der vorgeschalteten Hauptleitung; und
f) Korrektur (F6) der individuellen Leistungsaufnahme ($P_i$'), sodass eine im Bereich des Strangs zur individuellen Abgabe beobachtete plötzliche Schwankung des Stromverbrauchs gleich einer gleichzeitig im Bereich der vorgeschalteten Hauptleitung beobachteten plötzlichen Schwankung ist,

Verfahren, bei dem Schritt f) folgende Unterschritte umfasst:

- Zuordnung eines individuellen Korrekturkoeffizienten ($\alpha_i$) zur individuellen Leistungsaufnahme ($P_i$');
- gleichzeitige Erfassung (F61) einer Schwankung ($\Delta P_i$) der korrigierten individuellen Leistungsaufnahme und einer Schwankung ($\Delta$P) der Gesamtleistung;
- Berechnung (F62) eines Kalibrierungskoeffizienten ($R_i$), der gleich dem Verhältnis zwischen den Schwankungen ($\Delta$Pi, $\Delta$P) der individuellen Leistungsaufnahme und der Gesamtleistung ist;
- Anpassung (F63) des individuellen Korrekturkoeffizienten ($\alpha_i$) mittels des Kalibrierungskoeffizienten; und
- Zuordnung des individuellen Korrekturkoeffizienten ($\alpha_i$) zur individuellen Leistungsaufnahme ($P_i$');

**2.** Verfahren nach Anspruch 1, bei dem Schritt f) bei jedem Schließen des Schutzschalters (7) durchgeführt wird.

**3.** Verfahren nach einem der Ansprüche 1 bis 2, bei dem die Schritte b) bis d) bei allen Strängen zur individuellen Stromabgabe (3) durchgeführt werden.

**4.** Verfahren nach Anspruch 3, das ferner folgenden Schritt umfasst:
g) Korrektur (F7) der individuellen Leistungsaufnahme ($P_i$') jedes Strangs zur individuellen Abgabe (3), sodass die Summe der korrigierten individuellen Leistungsaufnahmen ($P_i$) gleich der Gesamtleistung (P) ist.

**5.** Verfahren nach Anspruch 4, bei dem Schritt g) folgende Unterschritte umfasst:

- Zuordnung eines individuellen Korrekturkoeffizienten ($\alpha_i$) zur individuellen Leistungsaufnehme ($P_i$') jedes Strangs zur individuellen Abgabe (3);
- Berechnung (F71) eines Gesamtkorrekturkoeffizienten, der gleich dem Verhältnis zwischen der Summe der korrigierten individuellen Leistungsaufnahmen und der Gesamtenergie (P) ist;
- Anpassung (F72) des individuellen Korrekturkoeffizienten ($\alpha_i$) jedes Strangs mittels des Gesamtkorrekturkoeffizienten ($\alpha_g$); und
- Zuordnung des individuellen Korrekturkoeffizienten ($\alpha_i$) zur individuellen Leistungsaufnahme ($P_i$') jedes Strangs.

**6.** Verfahren nach einem der Ansprüche 1 bis 5, bei dem die Berechnung der individuellen Leistungsaufnahme die Berechnung der individuellen Wirkleistung (P,) und der individuellen Blindleistung ($Q_i$) umfasst.

**7.** Verfahren nach Anspruch 6, das Schritte zur Berechnung eines Leistungsfaktors ($PF_i$) des Strangs zur indivduellen Abgabe und eines Mittelwerts ($I_{iM}$) des Stroms umfasst, der in dem Strang zur individuellen Abgabe (3) fließt.

**8.** Verfahren nach Anspruch 7, das folgende Schritte umfasst:

- Berechnung (F85) des Kontaktwiderstands ($RC_i$) des Schutzschalters (7) des Strangs zur individuellen Abgabe aus der Differenz zwischen der Spannung (U) der vorgeschalteten Hauptleitung (2) und der Spannung ($U_i$) des Strangs (3) zur individuellen Abgabe und des Mittelwerts ($I_{iM}$) des Stroms, der in dem Strang zur individuellen Abgabe fließt;
- Vergleich (F86) des Kontaktwiderstands mit einem Schwellenwert; und
- Auslösen (F87) eines Alarms, wenn der Kontaktwiderstand den Schwellenwert überschreitet.

**9.** Nachverfolgungssystem für eine individuelle Leistungsaufnahme in einer elektrischen Anlage (1), das eine Gruppe von Strängen (3) zur individuellen Stromabgabe und eine vorgeschaltete Hauptleitung (2) umfasst, die die Gruppe von Strängen an eine Stromversorgung (5) anschließt, wobei jeder Strang zur individuellen Stromabgabe einen Schutzschalter (7) umfasst,
wobei das Nachverfolgungssystem umfasst:

• ein Gerät zum Messen (8a) des Stroms (I) und der Spannung (U) im Bereich der vorgeschalteten Hauptleitung und zum Messen der Spannung ($U_i$) mindestens eines Strangs zur individuellen Abgabe hinter dem Schalter,
• einen Zähler (10) zum Zählen der von der Gruppe der Stränge verbrauchten Gesamtleistung (P) aus dem Strom (I) und der Spannung (U) der vorgeschalteten Hauptleitung;
• eine Berechnungsvorrichtung (9), die so vorgesehen ist, dass sie die individuelle Leistungsaufnahme ($P_i$', $Q_i$') des Strangs zur individuellen Abgabe (3) aus dem Strom ($I_i$), der in dem Strang zur individuellen Abgabe strömt, und der Spannung ($U_i$) des Strangs zur individuellen Abgabe berechnet;
• Mittel zur Korrektur ($\mu$P) der individuellen Leistungsaufnahme ($P_i$') durch Korrelation der plötzlichen Stromverbrauchsschwankungen, die gleichzeitig im Bereich des Strangs zur individuellen Abgabe (3) und der vorgeschalteten Hauptleitung (2) beobachtet wurden,

Nachverfolgungsvorrichtung, die **dadurch gekennzeichnet ist, dass** die Berechnungsvorrichtung (9) so vorgesehen ist, dass sie den Strom ($I_i$) des Strangs zur individuellen Abgabe aus der Differenz zwischen der Spannung (U) der vorgeschalteten Hauptleitung und der Spannung ($U_i$) des Strangs zur individuellen Abgabe berechnet, sowie dadurch, dass die Korrekturmittel ($\mu$P) so vorgesehen sind, dass sie:

- der individuellen Leistungsaufnahme ($P_i$') einen individuellen Korrekturkoeffizienten ($\alpha_i$) zuordnen;
- gleichzeitig eine Schwankung ($\Delta P_i$) der korrigierten individuellen Leistungsaufnahme und eine Schwankung ($\Delta$P) der Gesamtenergie erkennen (F61);
- einen Kalibrierungskoeffizienten ($R_i$), der gleich dem Verhältnis zwischen den Schwankungen ($\Delta$Pi, $\Delta$P) der individuellen Leistungsaufnahme und der Gesamtleistung ist, berechnen (F62);
- den individuellen Korrekturkoeffizienten ($\alpha_i$) mittels des Kalibrierungskoeffizienten (F63) aktualisieren; und den individuellen Korrekturkoeffizienten ($\alpha_i$) der individuellen Leistungsaufnahme ($P_i$') zuordnen.

## Claims

**1.** Method for determining an individual power consumption in an electric installation (1) comprising a group of individual electricity distribution branches (3) and an upstream main line (2) connecting the group of branches to an electric power supply (5), each individual electricity distribution branch comprising a circuit breaker (7),
method comprising the following steps:

a) measuring (F1) the current (I) flowing in the upstream main line and the voltage (U) of the upstream main line;
b) measuring (F2) the voltage ($U_i$) of at least one individual distribution branch (3), downstream from the circuit breaker (7);
c) determining (F3) the current ($I_i$) flowing in the individual distribution branch from the difference ($\Delta U_i$) between the voltage of the upstream main line and the voltage of the individual distribution branch;
d) calculating (F4) the individual power consumption ($P_i$') of the individual distribution branch from the current ($I_i$) and the voltage ($U_i$) of the individual distribution branch;
e) calculating (F5) the global power (P) consumed by the group of branches from the current (I) and the voltage (U) of the upstream main line; and
f) correcting (F6) the individual power consumption ($P_i$'), so that an instantaneous variation of electric consumption observed on the individual distribution branch is equal to an instantaneous variation of electric consumption observed simultaneously on the upstream main line,

method wherein step f) comprises the following substeps:

- assigning an individual correction coefficient ($\alpha_i$) to the individual power consumption ($P_i$');
- simultaneously detecting (F61) a variation ($\Delta P_i$) of the corrected individual power consumption and a variation ($\Delta P$) of the global power;
- calculating (F62) a calibration coefficient ($R_i$) equal to the ratio between the variations ($\Delta P_i$, $\Delta P$) of individual power consumption and of global power;
- updating (F63) the individual correction coefficient ($\alpha_i$) by means of the calibration coefficient; and
- assigning the individual correction coefficient ($\alpha_i$) to the individual power consumption ($P_i$').

**2.** Method according to claim 1, wherein step f) is performed on each closure of the circuit breaker (7).

**3.** Method according to either one of claims 1 or 2, wherein steps b) to d) are implemented for all the individual electricity distribution branches (3).

**4.** Method according to claim 3, further comprising the following step:
g) correcting (F7) the individual power consumption ($P_i$') of each individual consumption branch (3), so that the sum of the corrected individual power consumptions ($P_i$) is equal to the global power (P).

**5.** Method according to claim 4, wherein step g) comprises the following sub-steps:

- assigning an individual correction coefficient ($\alpha_i$) to the individual power consumption ($P_i$') of each individual distribution branch (3);
- calculating (F71) a global correction coefficient equal to the ratio between the sum of the corrected individual power consumptions and the global power (P);
- updating (F72) the individual correction coefficient ($\alpha_i$) of each branch by means of the global correction coefficient ($\alpha_g$); and
- assigning the individual correction coefficient ($\alpha_i$) to the individual power consumption ($P_i$') of each branch.

**6.** Method according to any one of claims 1 to 5, wherein calculation of the individual power consumption comprises calculation of the individual active power ($P_i$) and of the individual reactive power ($Q_i$).

**7.** Method according to claim 6, comprising steps of calculation of a power factor ($PF_i$) of the individual distribution branch and of a mean value ($I_{iM}$) of the current flowing in the individual distribution branch (3).

**8.** Method according to claim 7, comprising the following steps:

- calculating (F85) the contact resistance ($RC_i$) of the circuit breaker (7) of the individual branch, from the difference between the voltage (U) of the upstream main line (2) and the voltage ($U_i$) of the individual distribution branch (3), and from the mean value ($I_{iM}$) of the current flowing in the individual distribution branch;
- comparing (F86) the contact resistance with a threshold value; and
- triggering (F87) an alarm when the contact resistance is higher than the threshold value.

**9.** System of monitoring an individual power consumption in an electric installation (1) comprising a group of individual electricity distribution branches (3) and an upstream main line (2) connecting the group of branches to an electric power supply (5), each individual electricity distribution branch comprising a circuit breaker (7),
the system of monitoring comprising

- a measuring apparatus (8a) for measuring the current (I) and the voltage (U) in the upstream main line, and for measuring the voltage ($U_i$) of at least one individual distribution branch downstream from the circuit breaker;
- a meter (8a) for metering the global power (P) consumed by the group of branches, from the current (I) and the voltage (U) of the upstream main line;
- a calculating device (9) configured to calculate the individual power consumption ($P_i$', $Q_i$') of the individual distribution branch (3) from a current ($I_i$) flowing in the individual distribution branch and from the voltage ($U_i$) of the individual distribution branch; and
- correction means ($\mu$P) of the individual power consumption ($P_i$'), by correlation of the instantaneous variations of electric power consumption observed simultaneously on the individual distribution branch (3) and on the upstream main line (2);

system of monitoring **characterized in that** the calculating device (9) is configured to calculate the current ($I_i$) of the individual distribution branch, from the difference between the voltage (U) of the upstream main line and the voltage ($U_i$) of the individual distribution branch, and **in that** the correction means ($\mu$P) is configured to:

- assign an individual correction coefficient ($\alpha_i$) to the individual power consumption ($P_i$');
- simultaneously detect (F61) a variation ($\Delta P_i$) of the corrected individual power consumption and a variation ($\Delta$P) of the global power;
- calculate (F62) a calibration coefficient ($R_i$) equal to the ratio between the variations ($\Delta P_i$, $\Delta$P) of individual power consumption and of global power;
- update (F63) the individual correction coefficient ($\alpha_i$) by means of the calibration coefficient; and
- assign the individual correction coefficient ($\alpha_i$) to the individual power consumption ($P_i$').

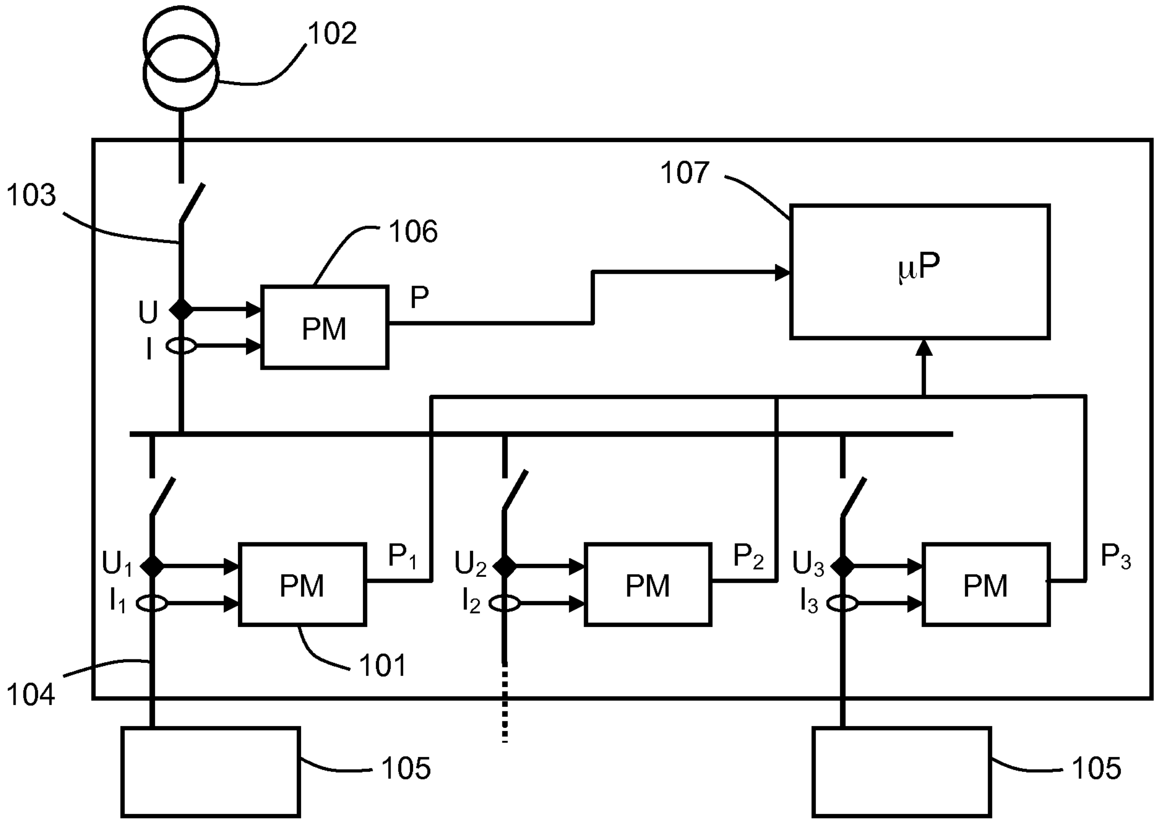


FIG. 1 (art antérieur)

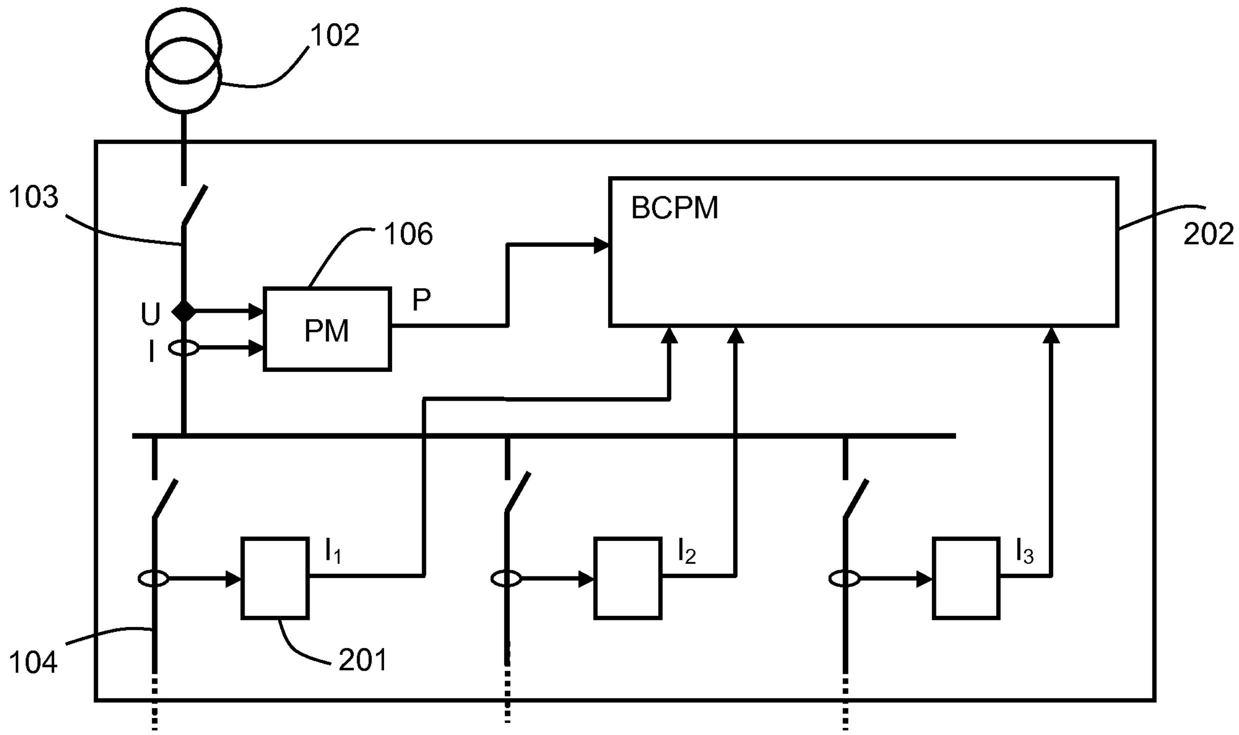


FIG. 2 (art antérieur)

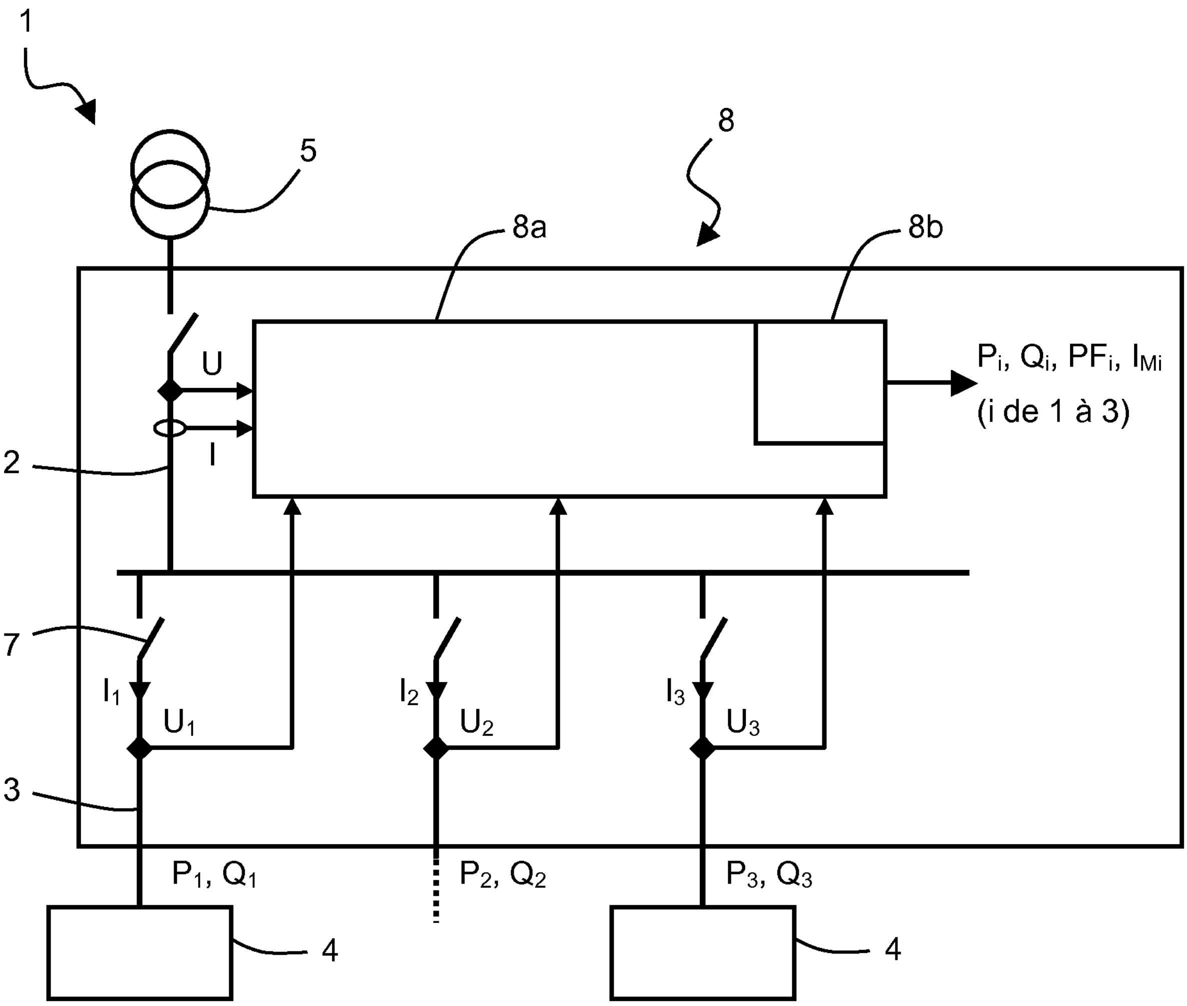
1
5
8
8a
8b
U
I
2
Pi, Qi, PFi, IMi
(i de 1 à 3)
7
I1
U1
I2
U2
I3
U3
3
P1, Q1
P2, Q2
P3, Q3
4
4

FIG. 3

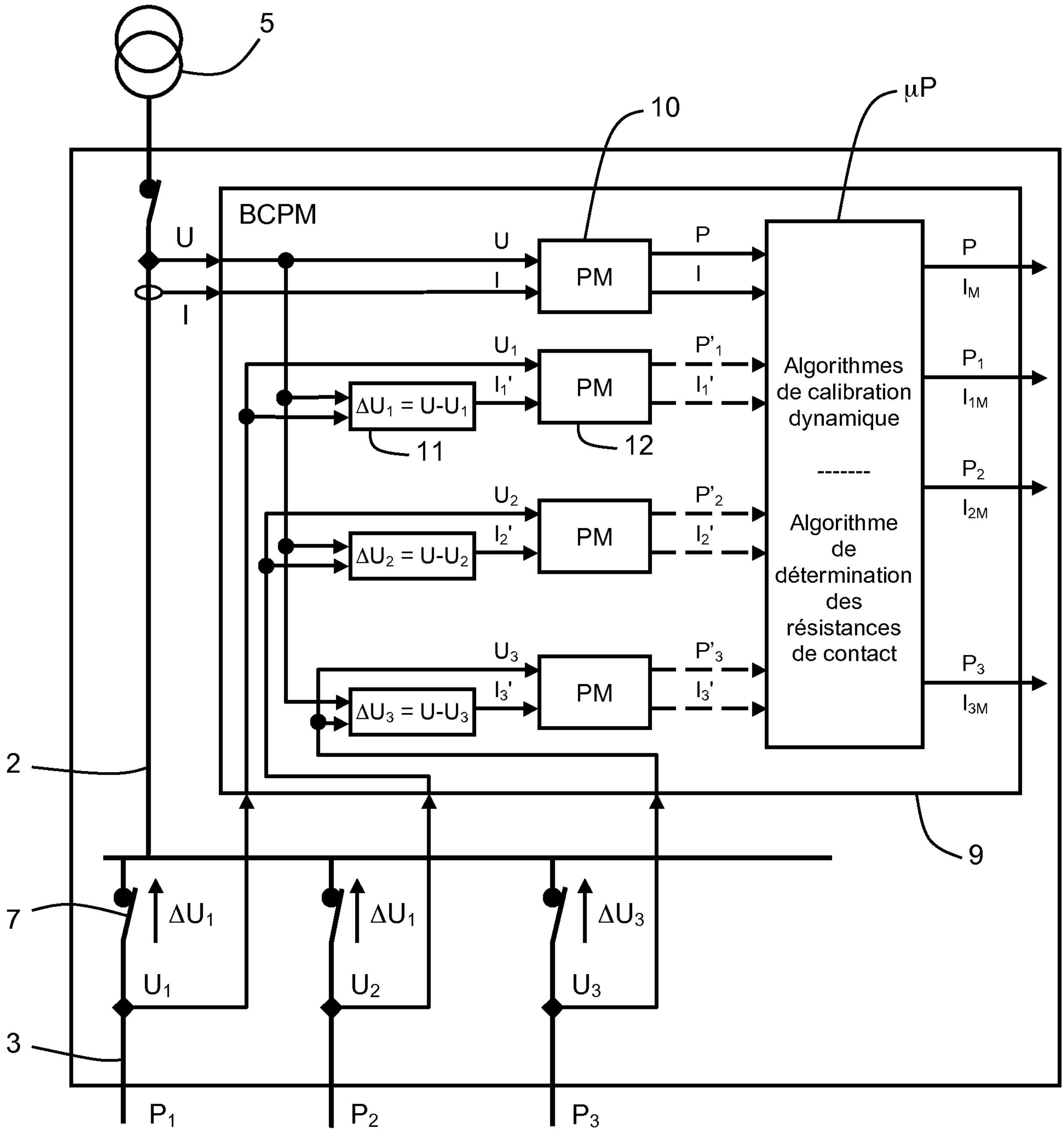
5
10
µP
BCPM
U
I
U
I
PM
P
I
P
$I_M$
$U_1$
$I_1'$
$\Delta U_1$ = U-$U_1$
PM
$P'_1$
$I_1'$
Algorithmes de calibration dynamique
-------
Algorithme de détermination des résistances de contact
$P_1$
$I_{1M}$
11
12
$U_2$
$I_2'$
$\Delta U_2$ = U-$U_2$
PM
$P'_2$
$I_2'$
$P_2$
$I_{2M}$
$U_3$
$I_3'$
$\Delta U_3$ = U-$U_3$
PM
$P'_3$
$I_3'$
$P_3$
$I_{3M}$
2
9
7
$\Delta U_1$
$\Delta U_1$
$\Delta U_3$
$U_1$
$U_2$
$U_3$
3
$P_1$
$P_2$
$P_3$

FIG. 4

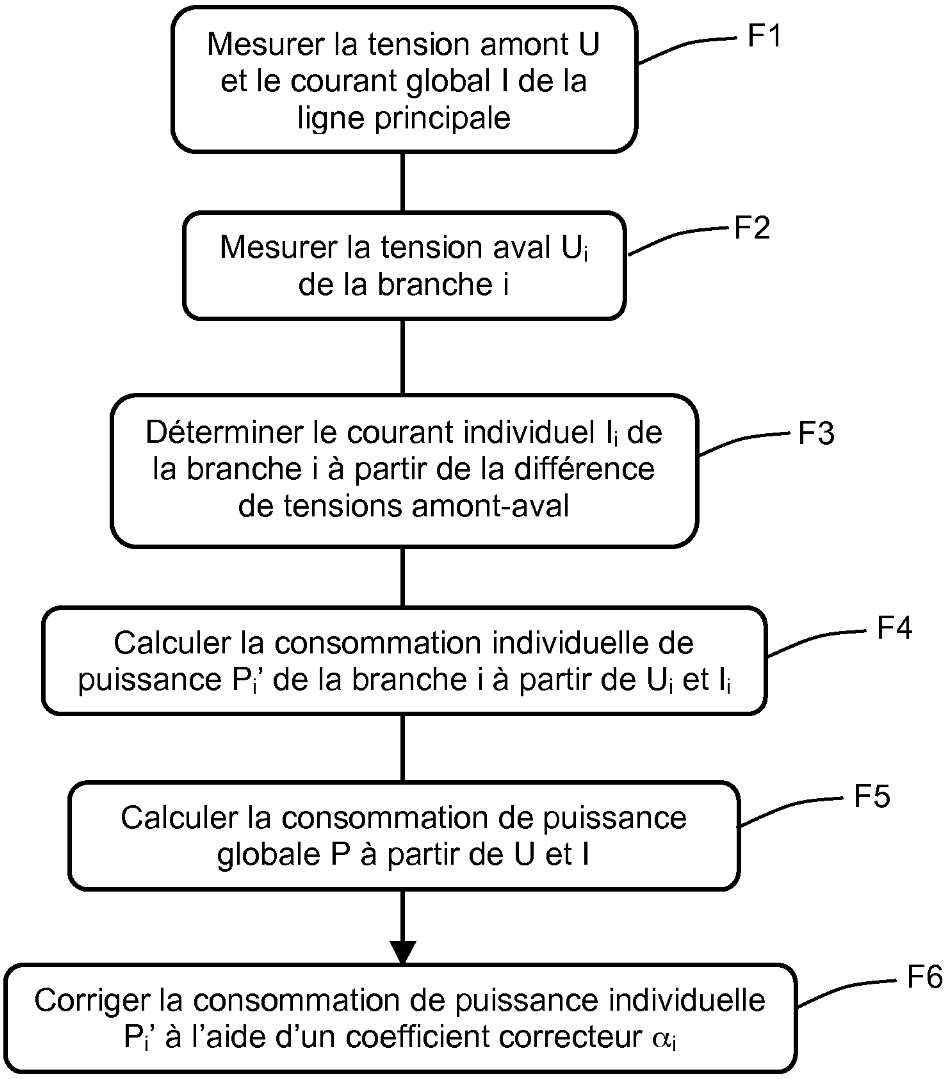
Mesurer la tension amont U et le courant global I de la ligne principale
F1
Mesurer la tension aval $U_i$ de la branche i
F2
Déterminer le courant individuel $I_i$ de la branche i à partir de la différence de tensions amont-aval
F3
Calculer la consommation individuelle de puissance $P_i$' de la branche i à partir de $U_i$ et $I_i$
F4
Calculer la consommation de puissance globale P à partir de U et I
F5
Corriger la consommation de puissance individuelle $P_i$' à l'aide d'un coefficient correcteur $\alpha_i$
F6

FIG. 5

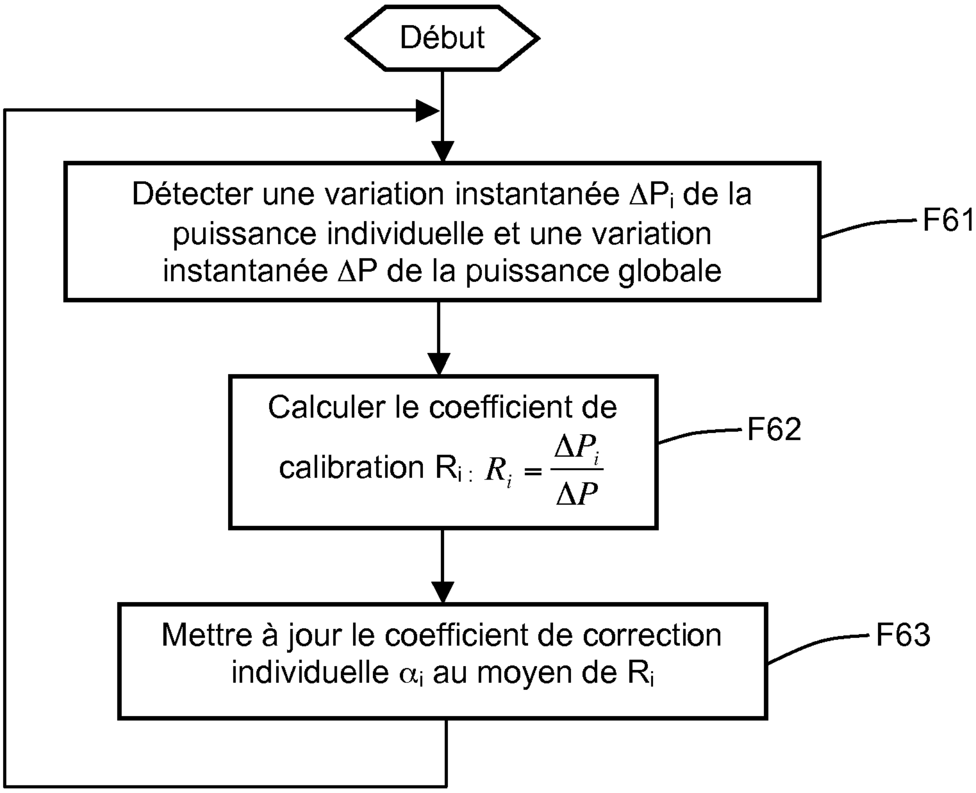
Début
Détecter une variation instantanée ΔPi de la puissance individuelle et une variation instantanée ΔP de la puissance globale
F61
Calculer le coefficient de calibration Ri : $R_i = \frac{\Delta P_i}{\Delta P}$
F62
Mettre à jour le coefficient de correction individuelle αi au moyen de Ri
F63

FIG. 6

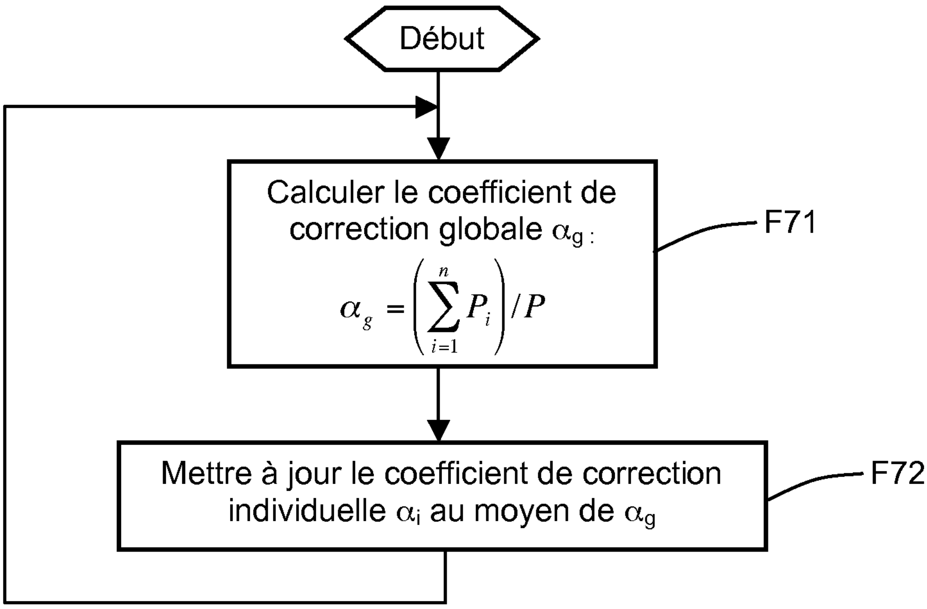
Début
Calculer le coefficient de correction globale αg : $\alpha_g = \left(\sum_{i=1}^{n} P_i\right)/P$
F71
Mettre à jour le coefficient de correction individuelle αi au moyen de αg
F72

FIG. 7

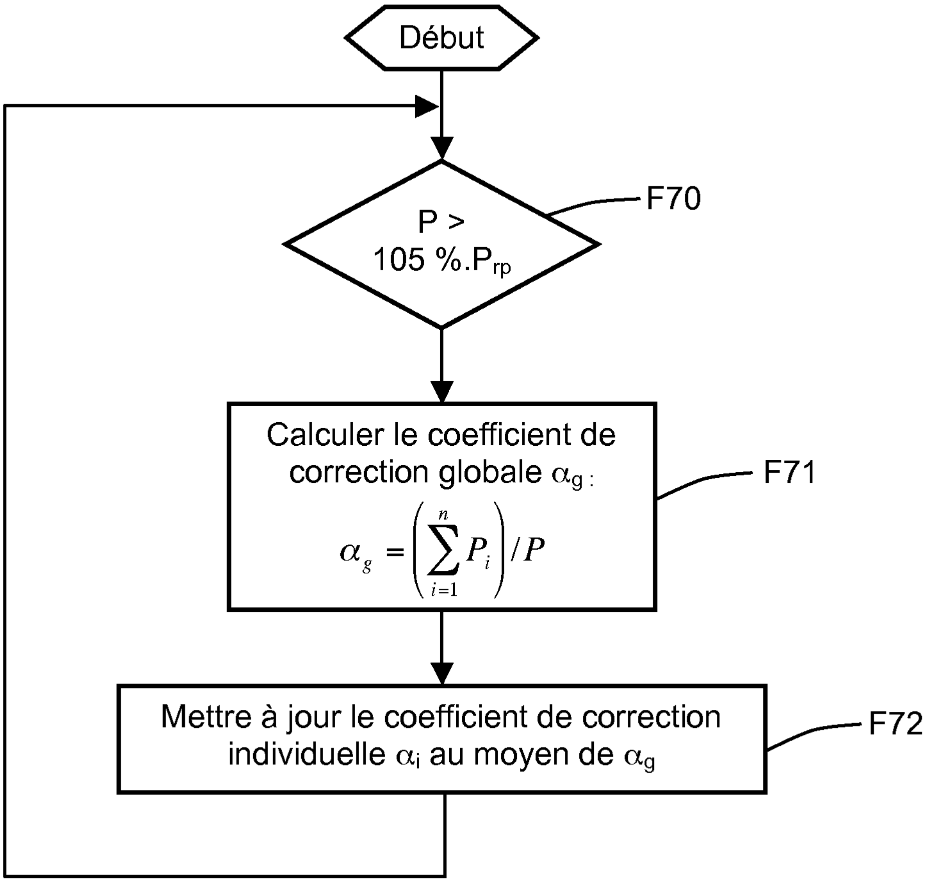
Début
P >
105 %.$P_{rp}$
F70
Calculer le coefficient de correction globale $\alpha_g$ :
$$\alpha_g = \left(\sum_{i=1}^{n} P_i\right)/P$$
F71
Mettre à jour le coefficient de correction individuelle $\alpha_i$ au moyen de $\alpha_g$
F72

FIG. 8

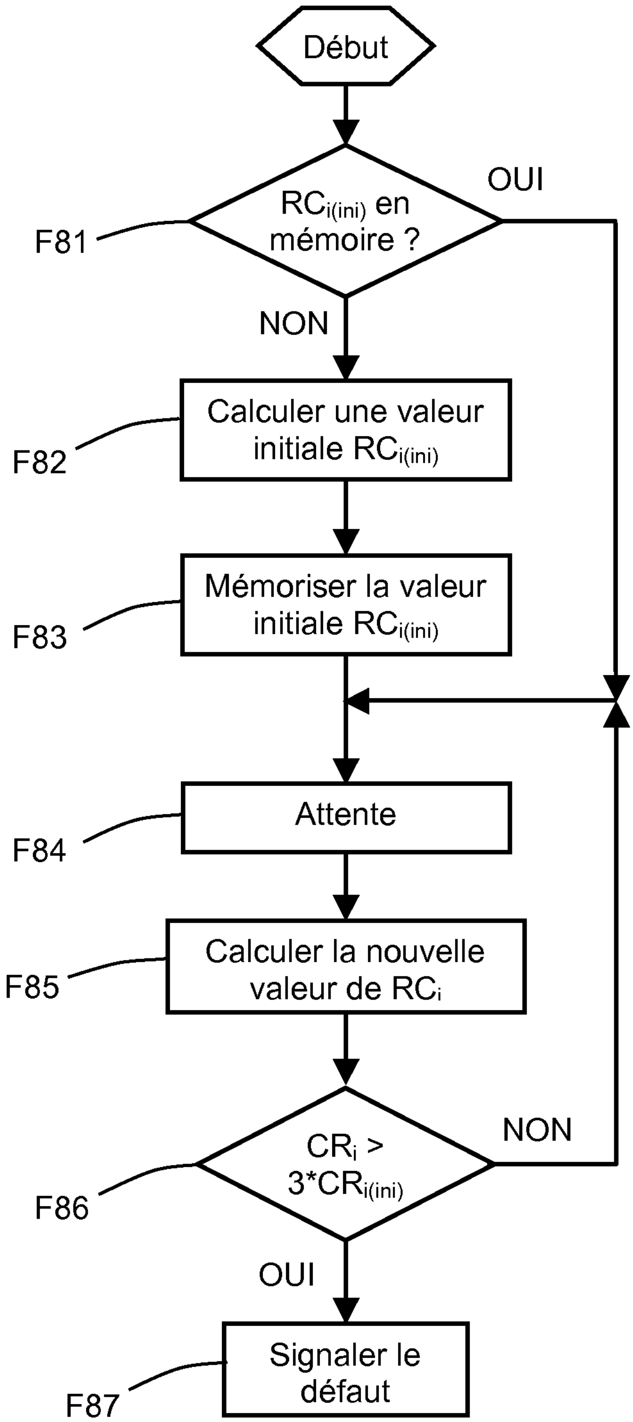
Début
$RC_{i(ini)}$ en mémoire ?
OUI
NON
F81
Calculer une valeur initiale $RC_{i(ini)}$
F82
Mémoriser la valeur initiale $RC_{i(ini)}$
F83
Attente
F84
Calculer la nouvelle valeur de $RC_i$
F85
$CR_i$ > 3*$CR_{i(ini)}$
NON
F86
OUI
Signaler le défaut
F87

FIG. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- FR 2984516